# EUROPEAN PATENT APPLICATION

(11) **EP 2 950 454 A1**
(43) Date of publication of application: **02.12.2015**
(21) Application number: 13872883.7
(22) Date of filing: 24.10.2013
(51) Int. Cl.: H04B 1/16

(54) **RECEIVING DEVICE AND CONTROL METHOD FOR RECEIVING DEVICE**

(30) Priority: 22.01.2013 JP 2013009061
(71) Applicant: Clarion Co., Ltd., Saitama-shi, Saitama 330-0081 (JP)
(72) Inventor: ARIKAWA, Yasushi, Saitama-shi Saitama 330-0081 (JP)
(74) Representative: Glawe, Delfs, Moll
(86) International application number: PCT/JP2013/078843
(87) International publication number: WO 2014/115388

(57) **Abstract**

There are provided a receiving device that can enhance the degree of freedom of sound volume correction by a construction of quantitatively variably controlling the gain of an antenna amplifier, and a method of controlling the receiving device.

The gain of a front end unit 31 functioning as an antenna amplifier is variably controlled with a predetermined unit on the basis of the reception intensity of electric waves by an AGC circuit unit 40, and sound volume correction is performed with a correction amount different depending on the gain of the front end unit 31 by a second sound volume correcting unit 48 of a tuner DSP 46.

## Description

### Technical Field

The present invention relates to a receiving device for receiving electric waves containing analog audio signals, and a control method for the receiving device.

### Background Art

An in-vehicle mount device including a radio receiver (receiving device) is known as one of in-vehicle mount devices which are mounted in vehicles. This type of radio receiver has an antenna amplifier unit for amplifying RF (Radio frequency) signals which are reception signals received by an antenna. The radio receiver selects signals of a receiving station from the signals amplified in the antenna amplifier unit, subjects the selected signals to demodulation processing, etc. and outputs analog audio signals of the reception station.

There has been known a device which has an AGC (Auto Gain Control) circuit for variably controlling the gain of an antenna amplifier unit in accordance with the intensity of received electrical waves and attenuates RF signals when the intensity of electric field increases, thereby suppressing distortion of an amplifier (see Patent Document 1, for example). This AGC circuit is also called as RFAGC (Radio Frequency Auto Gain Control).

### Prior Art Document

### Patent Document

Patent Document: JP-2007-243409

### Summary of the Invention

### Problem to be solved by the Invention

In the conventional construction, the RF signals are attenuated every predetermined unit (for example, every 6dB) when received electric field intensity reaches a threshold value at which the AGC circuit is turned on, and thus the optimum value of S meter level correction varies in accordance with whether the AGC circuit operates or not. Therefore, a relatively large sound volume variation such as sound volume fade or the like occurs in some cases.

The S meter represents the received electric field intensity of a reception frequency, and the optimum value of the S meter level correction is a signal level correction amount which is determined from the received electric field intensity. When the signal level is corrected to the optimum value, the signal level of audio signals is stabilized, and the sound volume variation is also suppressed within a proper range.

That is, in the conventional construction, only quantitatively fixed correction using a fixed value can be performed on the signal level, and thus it has been difficult to perform sound volume correction more flexibly.

The present invention has been implemented in view of the foregoing situation, and has an object to provide a receiving device that can enhance the degree of freedom of sound volume correction with a construction in which the gain of an antenna amplifier unit is quantitatively variably controlled, and a method of controlling the receiving device.

### Means of solving the Problem

In order to attain the above object, in order to attain the above object, a receiving device having an antenna amplifier that is supplied with reception signals of electric waves containing analog audio signals broadcasted from broadcast stations to amplify the reception signals, and acquires an analog audio signal of a reception station from the reception signals, is characterized by comprising: an AGC circuit unit that variably controlling a gain of the antenna amplifier with a predetermined unit on the basis of reception intensity of the electric waves; and a sound volume corrector that performs sound volume correction of the audio signal of the reception station with a correction amount that is different depending on the gain of the antenna amplifying unit.

According to this construction, according to the construction of quantitatively variably controlling the gain of the antenna amplifier, the degree of freedom of the sound volume correction can be enhanced as compared with the construction of only quantitatively fixed correction. Accordingly, sound volume correction can be more suitably performed by reduction of sound volume of a desired signal and improvement of S/N on auditory sensation.

The above construction further may comprise a tuner DSP that is supplied with an intermediate frequency signal obtained by converting the reception signal and performs signal processing on the intermediate frequency signal, and the tuner DSP may perform sound volume correction of the audio signal of the reception station with a correction amount that is different depending on the gain of the antenna amplifier. According to this construction, it is easy to change a receiving device having a conventional tuner DSP to the receiving device of the present invention.

In the above construction, table data for associating anAGCREADvalue corresponding to the gain of the antenna amplifier and a level offset value representing the correction amount may be stored, and the sound volume correcting unit may refer to the table data to specify a level offset value corresponding to a present AGCREAD value, and perform sound volume correction. According to this construction, the correction value which is different depending on the gain of the front end unit can be easily specified, and the correction amount can be easily changed.

The above construction may further comprise another sound volume correcting unit for performing sound volume correction with a predetermined unit according to the gain of the antenna amplifier. According to this construction, the sound volume correction can be performed with higher precision while another conventionally existing sound volume correcting unit is used.

In the above construction, the sound volume correcting unit may perform the sound volume correction so that an attenuation amount of a signal level is reduced to be less than an attenuation amount of a signal level when the sound volume correction is performed by only the other sound volume correcting unit in a predetermined area where the intensity of the electric waves is relatively high, and performs the sound volume correction so that the attenuation amount of the signal level is increased to be more than the attenuation amount of the signal level when the sound volume correction is performed by only the other sound volume correcting unit in a predetermined area where the intensity of the electric waves is relatively low. According to the construction, the reduction of the sound volume can be more greatly suppressed under such a condition that sufficient S/N is liable to be obtained, and noise on auditory sensation can be reduced by further reducing the sound volume under such a condition that sufficient S/N is difficult to be obtained.

Furthermore, according to the present invention, a method of controlling a receiving device having an antenna amplifier that is supplied with reception signals of electric waves containing analog audio signals broadcasted from broadcast stations to amplify the reception signals, and acquires an analog audio signal of a reception station from the reception signal is characterized by comprising: quantitatively variably controlling a gain of the antenna amplifier on the basis of reception intensity of the electric waves; and performing sound volume correction on an audio signal of the reception station with a correction amount which is different depending on the gain of the antenna amplifier. According to this construction, as compared with the construction capable of performing only quantitatively fixed correction, the degree of freedom of sound volume correction can be enhanced by the construction of quantitatively variably controlling the gain of the antenna amplifier. Accordingly, more suitable sound volume correction can be performed by reduction of the sound volume of a desired signal and improvement of S/N on auditory sensation.

### Effect of the Invention

According to the present invention, the degree of freedom of volume sound correction can be enhanced by the construction that the gain of the antenna amplifier can be quantitatively variably controlled.

### Brief Description of the Drawings

[Fig. 1] Fig. 1 is a block diagram showing the construction of an in-vehicle mount receiving device according to an embodiment of the present invention.
[Fig. 2] Fig. 2 is a block diagram showing the construction of a tuner IC.
[Fig. 3] Fig. 3 is a diagram showing the relationship between an AGCSTEP number and an attenuation amount of a signal level.
[Fig. 4] Fig. 4 is a flowchart showing a second sound volume correction.
[Fig. 5] Fig. 5 is a diagram showing a correction table. Mode for carrying out the Invention

An embodiment according to the present invention will be described hereunder with reference to the accompanying drawings.

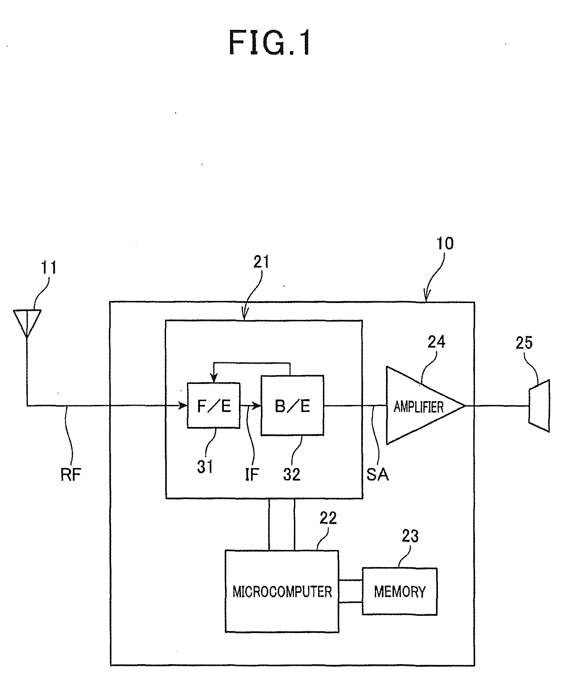

Fig. 1 is a block diagram showing the construction of an in-vehicle mount receiving device according to an embodiment of the present invention.

An in-vehicle mount receiving device 10 is a radio receiving device which is mounted in a vehicle such as a car or the like, and receives electric waves containing analog audio signals broadcasted from one or plural broadcast stations through an antenna 11 installed in the vehicle.

As shown in Fig. 1, the in-vehicle mount receiving device 10 has a tuner IC (tuner unit) 21 for converting an RF signal ("RF" in Fig. 1) as a reception signal received by the antenna 11 to an audio signal SA, a microcomputer 22 for controlling the tuner IC 21, a memory 23 for holding various kinds of data for controlling the tuner IC 21, and an amplifier 24 to which the audio signal SA is input to operate an external speaker 25.

The tuner IC 21 has a front end unit 31 ("F/E" in Fig. 1) and a back end unit 32 ("B/E" in Fig. 1).

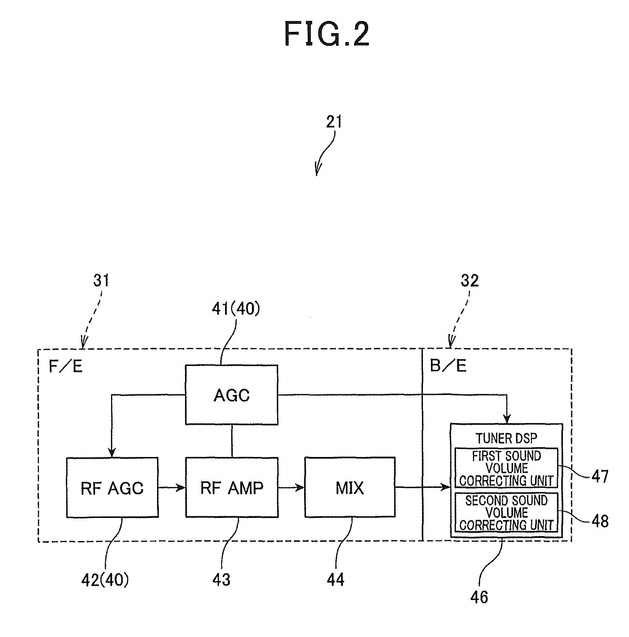

Fig. 2 is a block diagram showing the construction of the tuner IC 21.

The front end unit 31 functions as an antenna amplifier unit for amplifying the RF signal, etc. , and has an AGC circuit 41, an RF-AGC circuit 42, an RF-AMP circuit 43 and an MIX circuit (mixing circuit) 44.

The AGC circuit 41 and the RF-AGC circuit 42 function as an AGC circuit unit 40 for variably controlling the gain of the RF-AMP circuit 43 on the basis of the reception intensity of electrical waves (the intensity of the RF signal). The RF-AMP circuit 43 functions as an amplifying unit for amplifying the RF signal input to the front end unit 31 and outputting the amplified RF signal.

More specifically, the AGC circuit 41 detects the signal level of the RF signal input to the RF-AMP circuit 43, and controls the RF-AGC circuit 42 on the basis of the signal level, whereby the RF-AGC voltage output from the RF-AGC circuit 42 is variably controlled in a multistage style.

The RF-AMP circuit 43 variably controls the gain (gain) according to the RF-AGC voltage, whereby the gain is variably controlled on the basis of the reception intensity of the electrical waves.

According to the above construction, as the reception intensity of electrical waves increases, the RF signal is attenuated, and the RF signal can be attenuated so that the input level to the RF-AMP circuit 43 is not equal to a fixed level or more, whereby distortion of the amplifier can be suppressed.

As described above, the AGC circuit unit 40 functions as an automatic gain controller for variably controlling the gain in a multistage style so that the amplifier is not distorted. A conventional automatic gain control circuit can be broadly applied to the AGC circuit unit 40.

The MIX circuit 44 is a circuit for converting the RF signal as the reception signal output from the RF-AMP circuit 43 to an IF (Intermediate Frequency) signal ("IF" in Fig. 1) as an intermediate frequency signal by mixing the RF signal with a signal of a local oscillator (not shown).

The back end unit 32 has a tuner DSP (Digital Signal Processor) 46 for performing signal processing on an IF signal output from the front end unit 31.

The tuner DSP 46 isaprocessingunit for collectively performing the processing on the IF signal and subsequent processing, and also called as a signal processing tuner. The tuner DSP 46 roughly has a tuner module unit for tuning a signal of a reception station from an IF signal, an analog interface unit for performing analog-to-digital conversion on the IF signal from the tuner module unit, outputting the converted signal to an audio processor unit, converting a digital audio signal from the audio processor unit to an analog audio signal SA and outputting the analog audio signal SA, and an audio processor unit for executing various kinds of radio processing and audio processing on the digital IF signal input from the analog interface unit.

Digital processing such as noise removing processing, decoding processing, etc. are executed as the radio processing, and digital processing of sound volume control, sound quality control, etc. are executed as the audio processing.

As describe above, the analog audio signal SA of the reception station is output from the tuner DSP 46 and supplied to the amplifier 24 (Fig. 1), and the speaker 25 is driven by the amplifier 24, so that radio sounds desired by a user are emitted.

The AGC circuit portion 40 is configured to attenuate the gain of the RF-AMP circuit 43 every constant unit (every 6dB in this embodiment). In some cases, relatively large sound volume variation occurs or noise on auditory sensation becomes remarkable in accordance with whether the AGC circuit portion 40 operates or does not operate. In order to take a countermeasure to this phenomenon, in the in-vehicle mount receiving device 10, the tuner DSP 46 has a first sound volume correcting unit (quantitatively fixed sound-volume correcting unit) 47 for performing sound volume correction with a fixed unit (3dB unit in this embodiment) (hereinafter referred to as "first sound volume correction") in conformity with the attenuation level based on the AGC circuit unit 40, and the first sound volume correcting unit 47 suppresses the sound volume variation to some extent or reduces the sound volume when S/N is high, thereby reducing the noise on auditory sensation.

The first sound volume correcting unit 47 is constructed by algorithm processing for performing the first sound volume correction and data required for the algorithm processing, and the algorithm processing is executed according to a predetermined program, whereby the tuner DSP 46 functions as the first sound volume correcting unit 47.

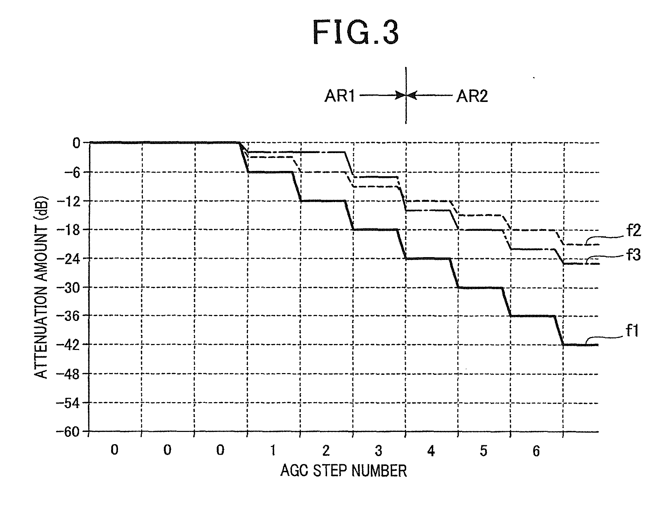

Here, Fig. 3 shows the relationship between the AGCSTEP number indicating the gain of the RF-AMP circuit 43, that is, the attenuation amount and the attenuation amount of the signal level.

In Fig. 3, a characteristic curve line f1 represented by a solid line represents a case where no sound volume correction is performed, that is, a case where the attenuation is performed with 6dB unit. Furthermore, a characteristic curve line f2 represented by a broken line represents a case where the first sound volume correction is performed.

As represented by the characteristic curve lines f1, f2 of Fig. 3, only quantitatively fixed correction using a fixed value can be performed by each of the AGC circuit unit 40 and the first sound volume correcting unit 47. Therefore, when the reception intensity of electric waves (the intensity of the RF signal) varies, the sound volume variation of a desired signal (audio signals of a reception station) intensifies or deterioration of S/N on auditory sensation occurs in some cases.

Therefore, according to this construction, the tuner DSP 46 is equipped with a second sound volume correcting unit 48 for performing sound volume correction with a correction amount which is different depending on the gain (attenuation amount) of the RF-AMP circuit 43 (hereinafter referred to as "second sound volume correction").

The second sound volume correcting unit 48 is constructed by an algorithm processing for performing the second sound volume correction and a correction table T1 described later. The algorithm processing is executed according to a predetermined program, whereby the tuner DSP 46 functions as the second sound volume correcting unit 48.

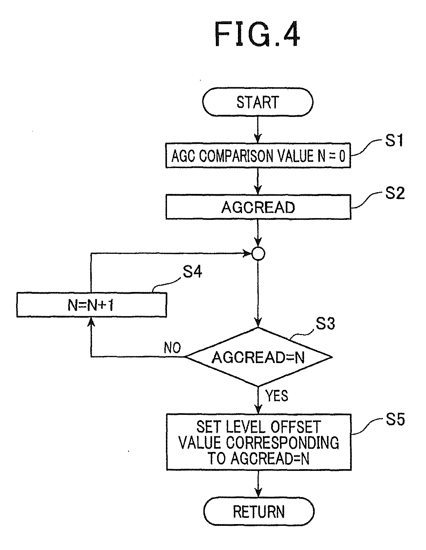

Fig. 4 is a flowchart showing the second sound volume correction. This sound volume correction is the processing which is started when the in-vehicle receiving device 10 is powered on and reception of signals starts.

First, the tuner DSP 46 set an AGC comparison value N to a value "0" (step S1), and acquires an AGCREAD value representing the AGC operation condition through the AGC circuit 41 (step S2). Here, the AGCREAD value is information corresponding to the gain (attenuation amount) of the RF-AMP circuit 43, and it is information coincident with the AGCSTEP number described above, for example.

Subsequently, the tuner DSP 46 compares the acquired AGCREAD value with the AGC comparison value (step S3). When the AGCREAD value and the AGC comparison value N are not coincident with each other (step S3; NO), the tuner DSP 46 increments the AGC comparison value N by "1" (step S4), and then shifts to step S3 to re-determine whether theAGCREAD value and the AGC comparison value N are coincident with each other or not.

Therefore, the value N is incremented until the AGCREAD value and the AGC comparison value N are coincident with each other, and when they are coincident with each other (step S3; YES), the tuner DSP 46 specifies the level offset value corresponding to the present AGCREAD value from the correction table T1 described later, and sets this level offset value (step S5). When the level offset value is set, the processing is shifted to the processing of the step S1, and the above processing is repeated.

As described above, the level offset value is set in accordance with the gain of the RF-AMP circuit 43, and when the level offset value is set, the tuner DSP 46 executes the level correction on the audio signal of the reception station on the basis of the set level offset value, thereby performing the sound volume correction of the audio signal SA.

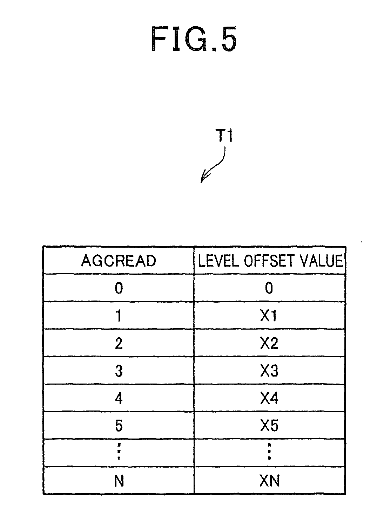

Fig. 5 shows the correction table T1.

As shown in Fig. 5, the correction table T1 is table data for associating the AGCREAD value and the level offset value in one-to-one correspondence.

The AGCREAD value is set to a value from value 0 to value N, and the value 0 corresponds to the value 0 of the AGCSTEP number shown in Fig. 3, the value 1 corresponds to the value 1 of the AGCSTEP number, .... , and the value N corresponds to the value N of the AGCSTEP number.

That is, when the AGCREAD value is equal to the value 0, the attenuation amount of the RF-AMP circuit 43 is equal to zero, and as the AGCREAD value is larger, the attenuation amount of the RF-AMP circuit 43 increases.

As shown in Fig. 5, the level offset value of the value 0 is allocated to the value 0 of the AGCREAD value. Accordingly, when the attenuation amount is equal to zero, that is, when the intensity of the RF signal (the intensity of the received electric field) is highest, the level offset value is set to zero, so that no level correction is performed and the sound value is not reduced.

Furthermore, as shown in Fig. 5, the level offset values of value X1 to value XN are individually allocated to the value 1 to the value N of the AGCREAD value.

These level offset values are set in consideration of the operation condition of the AGC circuit unit 40 and the effect of a disturbing signal to a desired signal (an audio signal of a reception station) in a road test under which the in-vehicle mount receiving device 10 is mounted in an actual vehicle. Points to be considered are interference of the disturbing signal in the desired signal, reduction of the sound volume of the desired signal, deterioration of S/N of the desired signal, etc., and level offset values for improving the reduction of the sound volume of the desired signal and the deterioration of S/N respectively are set independently of each other.

Here, in Fig. 3, a characteristic curve line f3 represented by a one-broken chain line represents a specific example when the level correction is performed with level offset values based on the correction table T1 (when the second sound volume correction is further performed).

In Fig. 3, an area where the intensity of the RF signal (the intensity of the received electric field) is relatively high is represented by AR1, and an area where the intensity of the RF signal is relatively low is represented by AR2.

In the area AR1, the level of the disturbing signal is low, and some degree of level can be secured for the desired signal. Therefore, under this condition, sufficient S/N is liable to be obtained. Therefore, in the area AR1, the level offset value is set so as to reduce the attenuation amount more greatly as represented by the characteristic curve line f3 in Fig. 3 as compared with the characteristic curve line f2.

Specifically, when the AGCSTEP number is equal to the value 1, the attenuation amount is equal to -3dB in the characteristic curve line f2, but it is equal to -2dB due to the level offset value X1 in the characteristic curve line f3. Furthermore, when the AGCSTEP number is equal to the value 2, the attenuation amount is equal to -6dB in the characteristic curve line f2, but it is equal to -2dB due to the level offset value X2 in the characteristic curve line f3. Still furthermore, when the AGCSTEP number is equal to the value 3, the attenuation amount is equal to -9dB in the characteristic curve line f2, but it is equal to -7dB due to the level offset value X3 in the characteristic curve line f3.

Accordingly, the reduction of the sound volume can be more greatly suppressed under such a condition that sufficient S/N is liable to be obtained.

On the other hand, the area AR2 is under a condition that the level of the disturbing signal is high and sufficient S/N is difficult to be obtained. Therefore, in the area AR2, the level offset value is set so that the attenuation amount is increased more greatly as shown in the characteristic curve line f3 in Fig. 3 as compared with the characteristic curve line f2.

Specifically, when the AGCSTEP number is equal to the value 4, the attenuation amount is equal to -12dB in the characteristic curve line f2, but it is equal to -14dB due to the level offset value X4 in the characteristic curve line f3. Furthermore, when the AGCSTEP number is equal to the value 5, the attenuation amount is equal to -15dB in the characteristic curve line f2, but it is equal to -18dB due to the level offset value X5 in the characteristic curve line f3. Furthermore, when the AGCSTEP number is equal to the value 6 or 7, the attenuation amount is more greatly increased in the characteristic curve line 3 as compared with the characteristic curve line 2.

Accordingly, under such a condition that sufficient S/N is difficult to be obtained, the sound volume is more greatly reduced to reduce the noise on auditory sensation.

As described above, the gain of the front end unit 31 functioning as the antenna amplifying unit is variably controlled with a predetermined unit on the basis of the reception intensity of electric waves by the AGC circuit unit 40, and the sound volume correction is performed with the correction amount varying according to the gain of the front end unit 31 by the second sound volume correcting unit 48 of the tuner DSP 46. Therefore, as comparison with the device for performing only quantitatively fixed correction, the degree of freedom of the sound volume correction is enhanced and more proper sound volume correction can be performed by the reduction of the sound volume of the desired signal and the improvement of S/N on auditory sensation. Furthermore, it is unnecessary to vary the sound correction amount every gain of the front end unit 31, and the same correction amount may be set. In short, the correction amount may be arbitrarily set in such a range that the proper sound volume correction can be performed.

Furthermore, the tuner DSP 46 which performs the signal processing on the IF signal performs the sound volume correction with a different correction amount every gain of the front end unit 31, so that it is easy to change the in-vehicle mount receiving device having the conventional tuner DSP to the in-vehicle mount receiving device 10 of this invention. For example, it can be dealt with by exchanging the tuner DSP or adding the tuner DSP with a function or the like.

Furthermore, according to this construction, the correction table T1 which associates the AGCREAD value corresponding to the gain of the front end unit 31 with the level offset value representing the correction amount is stored, and the level offset value corresponding to the present AGCREAD value is specified by referring to the correction table T1, thereby performing the sound volume correction. Therefore, the correction amount which is different depending on the gain of the front end unit 31 can be easily specified, and the change of the correction amount can be easily performed.

Furthermore, the in-vehicle mount receiving device 10 of this construction has the first sound volume correcting unit (another sound volume correcting unit) 48 for performing the sound volume correction with a predetermined unit for each gain of the front end unit 31. Therefore, the sound volume correction which is insufficient by using even the first volume correcting unit 47 can be supplemented by the second sound volume correcting unit 48. Accordingly, the sound volume correction can be performed with higher precision while the conventionally existing first sound volume correcting unit 47 is used. Furthermore, the correction amount for the sound volume correction (the second sound volume correction) using the correction table T1 may be reduced to a small amount by the amount corresponding to the correction of the first sound volume correcting unit 47.

The above embodiment is merely an aspect of the present invention, and any modification may be made within the scope of the present invention. For example, in the above embodiment, the in-vehicle mount receiving device 10 has the first sound volume correcting unit 47. However, the present invention is not limited to the embodiment, and the first sound volume correcting unit 47 may be omitted.

Furthermore, in the above embodiment, the present invention is applied to the in-vehicle mount receiving device 10. However, the present invention is not limited to this style, and may be broadly applied to a receiving device equipped in an in-vehicle mount device such as a car navigation device, an in-vehicle mount audio device for reproducing CD or the like. Furthermore, the present invention may be applied to a receiving device other than the in-vehicle mount device or electronic equipment having a receiving device.

### Description of Reference Numerals

- 10: in-vehicle mount receiving device
- 21: tuner IC (tuner unit)
- 31: front end unit (antenna amplifying unit)
- 32: back end unit
- 40: AGC circuit unit
- 41: AGC circuit
- 42: RF-AGC circuit
- 43: RF-AMP circuit (amplifying unit)
- 44: MIX circuit (mixing circuit)
- 46: tuner DSP (signal processing tuner)
- 47: first sound volume correcting unit (quantitatively fixed sound volume correcting unit)
- 48: second sound volume correcting unit
- T1: correction table (table data)

## Claims

1. A receiving device having an antenna amplifier that is supplied with reception signals of electric waves containing analog audio signals broadcasted from broadcast stations to amplify the reception signals, and acquires an analog audio signal of a reception station from the reception signals, comprising:
an AGC circuit unit that variably controlling a gain of the antenna amplifier with a predetermined unit on the basis of reception intensity of the electric waves; and
a sound volume corrector that performs sound volume correction of the audio signal of the reception station with a correction amount that is different depending on the gain of the antenna amplifying unit.

2. The receiving device according to claim 1, further comprising a tuner DSP that is supplied with an intermediate frequency signal obtained by converting the reception signal and performs signal processing on the intermediate frequency signal, wherein the tuner DSP performs sound volume correction of the audio signal of the reception station with a correction amount that is different depending on the gain of the antenna amplifier.

3. The receiving device according to claim 1, wherein table data for associating an AGCREAD value corresponding to the gain of the antenna amplifier and a level offset value representing the correction amount are stored, and the sound volume correcting unit refers to the table data to specify a level offset value corresponding to a present AGCREAD value, and performs sound volume correction.

4. The receiving device according to claim 1, further comprising another sound volume correcting unit for performing sound volume correction with a predetermined unit according to the gain of the antenna amplifier.

5. The receiving device according to claim 1, wherein the sound volume correcting unit performs the sound volume correction so that an attenuation amount of a signal level is reduced to be less than an attenuation amount of a signal level when the sound volume correction is performed by only the other sound volume correcting unit in a predetermined area where the intensity of the electric waves is relatively high, and performs the sound volume correction so that the attenuation amount of the signal level is increased to be more than the attenuation amount of the signal level when the sound volume correction is performed by only the other sound volume correcting unit in a predetermined area where the intensity of the electric waves is relatively low.

6. A method of controlling a receiving device having an antenna amplifier that is supplied with reception signals of electric waves containing analog audio signals broadcasted from broadcast stations to amplify the reception signals, and acquires an analog audio signal of a reception station from the reception signals, comprising:
quantitatively variably controlling a gain of the antenna amplifier on the basis of reception intensity of the electric waves; and
performing sound volume correction on an audio signal of the reception station with a correction amount which is different depending on the gain of the antenna amplifier.
